# EUROPEAN PATENT APPLICATION

(11) **EP 4 852 001 A1**
(43) Date of publication of application: **09.12.2026**
(21) Application number: 26178996.0
(22) Date of filing: 15.05.2026
(51) Int. Cl.: G11C 13/00

(54) **LOGICAL OPERATIONS IN MEMORY**

(30) Priority: 06.06.2025 US 202563819101 P
(71) Applicant: MICRON TECHNOLOGY, INC., Boise, ID 83716-9632 (US)
(72) Inventor: LU, Zhongyuan, Boise, 83706 (US); GLEIXNER, Robert J., San Jose, 95126 (US)
(74) Representative: Gill Jennings & Every LLP

(57) **Abstract**

The present disclosure includes apparatuses and methods for logical operations in memory. An example apparatus may include a plurality of memory cells, and a plurality of buffer cells. Control circuitry may be configured to perform a logical operation. The controller may apply a first voltage across a first memory cell of the plurality of memory cells and a first buffer cell of the plurality of buffer cells. A state of the first buffer cell may be the opposite of the state of the first memory cell as a result of the first voltage. The controller may apply a second voltage across a second memory cell of the plurality of memory cells and the first buffer cell. A result of the logical operation may be stored on the second memory cell as a result of the second voltage being applied.

## Description

### Technical Field

The present disclosure relates generally to semiconductor memory and methods, and more particularly, to COPY and NOT operations in memory.

### Background

Memory devices are typically provided as internal, semiconductor, integrated circuits and/or external removable devices in computers or other electronic devices. There are many different types of memory including volatile and non-volatile memory. Volatile memory can require power to maintain its data and can include random-access memory (RAM), dynamic random access memory (DRAM), and synchronous dynamic random access memory (SDRAM), among others. Non-volatile memory can provide persistent data by retaining stored data when not powered and can include NAND flash memory, NOR flash memory, read only memory (ROM), and resistance variable memory such as phase change random access memory (PCRAM), resistive random access memory (RRAM), and magnetic random access memory (MRAM), among others.

Memory devices can be utilized as volatile and non-volatile memory for a wide range of electronic applications in need of high memory densities, high reliability, and low power consumption. Non-volatile memory may be used in, for example, personal computers, portable memory sticks, solid state drives (SSDs), personal digital assistants (PDAs), digital cameras, cellular telephones, portable music players, for example, MP3 players, and movie players, among other electronic devices. Data, such as program code, user data, and/or system data, such as a basic input/output system (BIOS), are typically stored in non-volatile memory devices.

Resistance variable memory such as PCRAM includes resistance variable memory cells that can store data based on the resistance of a storage element (e.g., a storage element having a variable resistance). As such, resistance variable memory cells can be programmed to store data corresponding to a target state by varying the resistance level of the resistance variable storage element. Resistance variable memory cells can be programmed to a target state (e.g., logical state) corresponding to a particular resistance, by applying sources of an electrical field or energy, such as positive or negative electrical signals (e.g., positive or negative voltage or current signals) to the cells.

Various computing architectures (e.g., Von Neumann architectures) include a bottleneck issue associated with data transfer between memory (e.g., a memory device storing data) and a processing resource (e.g., a central processing unit) used to perform compute functions on data (e.g., via logical operations such as Boolean logic operations and/or higher level mathematical operations) in association with executing instructions (e.g., a program). Some memory devices are capable of in-memory computing, which can include performing logical operations between data values stored in a memory array without transferring the data out of the array (e.g., to an external processing resource).

### Brief Description of the Drawings

Figure 1A illustrates a memory system capable of performing COPY and NOT operations in accordance with a number of embodiments of the present disclosure.
Figure 1B illustrates an example of a memory array capable of storing data values on which COPY and NOT operations can be performed in accordance with a number of embodiments of the present disclosure.
Figure 2A illustrates threshold voltage distributions associated with states of memory cells on which COPY and NOT operations can be performed in accordance with a number of embodiments of the present disclosure.
Figures 2B-2C are graphs illustrating current-versus-voltage signatures associated with memory cells on which COPY and NOT operations can be performed in accordance with a number of embodiments of the present disclosure.
Figures 3A-3B are diagrams illustrating memory cells capable of storing values associated with COPY and NOT operations in accordance with a number of embodiments of the present disclosure.
Figure 3C illustrates threshold voltage distributions associated with states of memory cells connected in series in accordance with a number of embodiments of the present disclosure.
Figure 4 illustrates a number of memory cells in association with performing COPY and NOT operations in accordance with a number of embodiments of the present disclosure.
Figure 5 illustrates a number of memory cells in association with performing COPY and NOT operations in accordance with a number of embodiments of the present disclosure.
Figure 6 illustrates a portion of a memory array including memory cells that can be operated to perform a COPY or NOT operation in accordance with a number of embodiments of the present disclosure.
Figure 7 illustrates a portion of a memory array including memory cells that can be operated to perform a COPY or NOT operation in accordance with a number of embodiments of the present disclosure.
Figure 8 illustrates a portion of a memory array including memory cells that can be operated to perform COPY and NOT operations in accordance with a number of embodiments of the present disclosure.
Figure 9 is a flow diagram corresponding to a method for performing one or more logical operations in accordance with some embodiments of the present disclosure.

### Detailed Description

The present disclosure includes apparatuses and methods for COPY and NOT operations in memory. An example apparatus may include a plurality of memory cells, and a plurality of buffer cells. The apparatus may also have control circuitry. The control circuitry may be configured to perform a logical operation in response to a dedicated command. To complete the logical operation, the controller may apply a first voltage having a first polarity across a first memory cell of the plurality of memory cells and a first buffer cell of the plurality of buffer cells. A first portion of the first voltage may be applied to a respective second end of the first memory cell and a respective first end of the first buffer cell. A logical state of the first memory cell may be unchanged as a result of the first voltage being applied and logical state of the first buffer cell may be the opposite of the state of the first memory cell. The controller may apply a second voltage having a second polarity across a second memory cell of the plurality of memory cells and the first buffer cell. A first portion of the second voltage may be applied to a respective second end of the second memory cell and a respective first end of the first buffer cell. A result of the logical operation may be stored on the second memory cell as a result of the second voltage being applied.

Embodiments of the present disclosure provide various benefits such as reduced cost associated with a memory device capable of performing various in-memory compute operations (e.g., Boolean logical operations) compared to previous approaches. For example, the present disclosure may simplify a circuit design for a memory array that is capable of performing a NOT or COPY operation within the memory array (e.g., without transferring data associated with the NOT or COPY operation out of the memory array). For example, the ability to perform a NOT operation in memory allows for a COPY operation to be performed by executing a first NOT operation and then executing a second NOT operation on the result of the first NOT operation (such that the result of the second NOT operation is analogous to an input of the first NOT operation, resulting in a "COPY" of the input). As used herein, the term "NOT operation" refers to a logical rule wherein the output is the inverse of the input. As used herein, the term "COPY operation" refers to a logical rule wherein the output is the same as the input.

In-memory compute operations as described herein can be performed without having to read data values from an array into sense amplifiers, for example, which can result in consuming less power as compared to various previous approaches to in-memory computing. As described further herein, embodiments can include performing a NOT or COPY operation in memory without the use of an external load resistor such as employed by some previous in-memory computing approaches.

In the following detailed description of the present disclosure, reference is made to the accompanying drawings that form a part hereof, and in which is shown by way of illustration how one or more embodiments of the disclosure may be practiced. These embodiments are described in sufficient detail to enable those of ordinary skill in the art to practice the embodiments of this disclosure, and it is to be understood that other embodiments may be utilized and that process, electrical, and structural changes may be made without departing from the scope of the present disclosure.

As used herein, designators such as "N" and "M", particularly with respect to reference numerals in the drawings, indicate that a number of the particular feature so designated can be included. It is also to be understood that the terminology used herein is for the purpose of describing particular embodiments only, and is not intended to be limiting. As used herein, the singular forms "a", "an", and "the" can include both singular and plural referents, unless the context clearly dictates otherwise. In addition, "a number of" something (e.g., a number of memory cells) can refer to one or more of such things, whereas a "plurality of" is intended to refer to more than one of such things (e.g., more than one memory cell). Furthermore, the words "can" and "may" are used throughout this application in a permissive sense (e.g., having the potential to, being able to), not in a mandatory sense (e.g., required to).

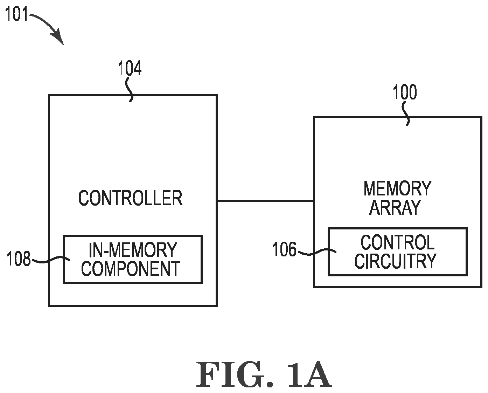

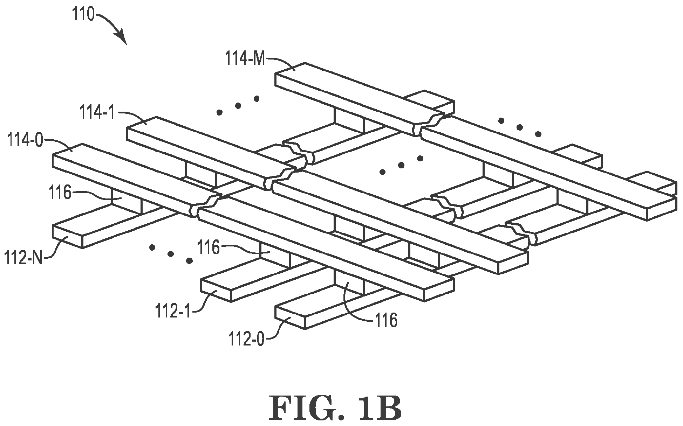

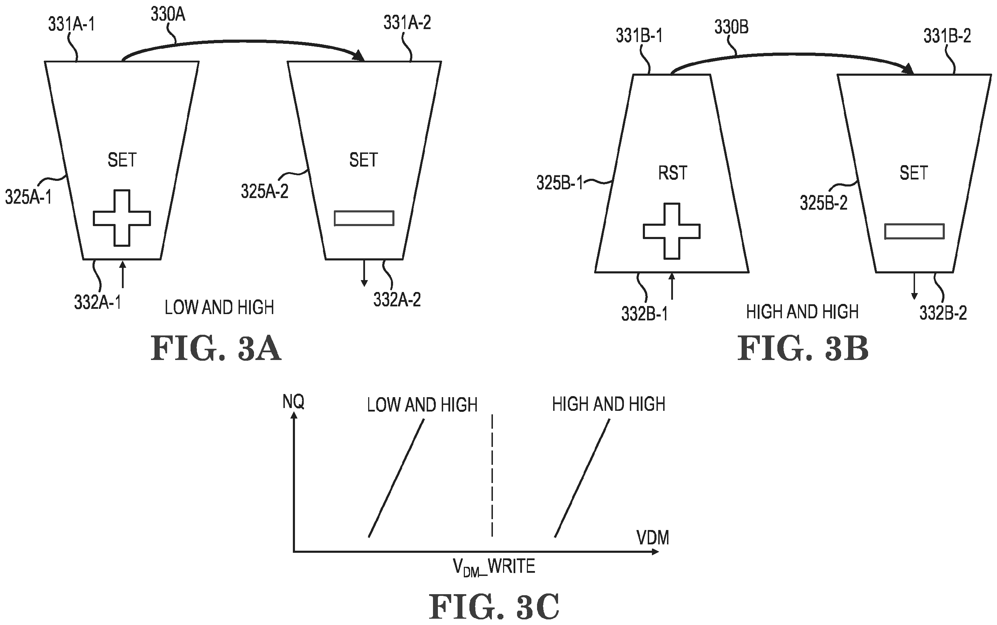

The figures herein follow a numbering convention in which the first digit or digits correspond to the drawing figure number and the remaining digits identify an element or component in the drawing. Similar elements or components between different figures may be identified by the use of similar digits. For example, 114 may reference element "14" in Figure 1, and a similar element may be referenced as 314 in Figure 3.

Figure 1A illustrates a memory system 101 capable of performing COPY and NOT operations in accordance with a number of embodiments of the present disclosure. As shown in Figure 1A, the memory system 101 includes a memory array 100 and a controller 104.

The controller 104 can communicate with the memory array 100 to perform memory operations such as read, write, and/or erase operations. As an example, the controller 104 can be on a same die or a different die than a die or dice corresponding to the memory array 100. The controller 104 can include, for example, a number of components in the form of hardware and/or firmware (e.g., one or more integrated circuits such as an in-memory component 108) and/or software for controlling access to the memory array 100 and/or for facilitating data transfer between the memory array 100 and a requesting device (e.g., host, not shown, but which may be coupled to the memory system 100).

The controller 104 is capable of providing signals to array 100 to perform memory operations such as reads and writes. In a number of examples, the controller 104 may be configured to provide signals to the array 100 to perform in-memory compute operations such as NOT operations and/or other Boolean logic operations as described further herein. A signal provided by the controller 104 may be a dedicated command, which causes a particular in-memory compute operation, such as a COPY or NOT operation, to be performed on the memory array 100.

The memory array 100 may serve as a memory for the memory system 101. The memory array 100 may include memory cells that are resistance variable memory cells. For example, states (e.g., logical states) of the memory cells may be determined based on resistance (e.g., corresponding voltages) of the memory cells that are variable responsive to voltages applied across the memory cells. As described further herein, the memory cells of the memory array 100 may be capable of storing a value corresponding to an input and a value corresponding to an output of a NOT or COPY operation that may be performed within the memory array 100.

The memory array 100 can be closely coupled to control circuitry 106. Alternatively, the control circuitry 106 can be an internal controller, which can be included in a same die as the memory array 100. For example, an internal controller might be a state machine or a memory sequencer. Control circuitry 106 may decode signals provided from controller 104. These signals may include chip signals, write enable signals, and address latch signals that are used to control the operations on memory array 100, including data read and data write operations as well as logical operations (e.g., material implication, FALSE, NOT, COPY operations, etc.) as requested/directed by dedicated commands as described herein.

The controller 104 further comprises an in-memory component 108, which can include various special purpose circuitry in the form of an ASIC, FPGA, state machine, and/or other logic circuitry that can perform operations described herein. For example, the in-memory component 108 can issue a dedicated command that can cause the memory array 100 to perform various in-memory operations (e.g., compute and/or logical operations). This dedicated command issued by the controller 104 (e.g., by the in-memory component 108) can cause the memory array 100 to perform bulk logical and/or compute operations. More particularly, multiple logical and/or compute operations can be performed in parallel (alternatively referred to as "substantially simultaneously") using memory cells of a three-dimensional (3D) memory array.

In-memory operations described herein do not involve reading source data (e.g., data on which logical and/or compute operations are to be performed) to the controller 104 and write the result of the operations back to the memory array 100. As such, for example, in-memory operations as described herein can be performed without having to read data values from an array into sense amplifiers (e.g., without firing a column and/or row decode signal), reducing latencies and power consumption. This results in increased bandwidth for in-memory operations.

Figure 1B illustrates an example of a memory array 100 capable of storing data values on which COPY and NOT operations can be performed in accordance with a number of embodiments of the present disclosure. Although not specifically illustrated in Figure 1B, in various embodiments, the array 100 may also be a three-dimensional (3D) cross-point array, which might comprise multiple tiers of array 100 stacked (e.g., vertically) on each other.

The example shown in Figure 1B is a cross-point memory array; however, embodiments are not so limited. Memory array 100 includes a plurality of access lines 112-0 to 112-N (e.g., which may be referred to as word lines 112), and a plurality other access lines 114-0 to 114-M (e.g., which may be referred to as bit lines 114) that cross each other (e.g., intersect in different planes). Memory cells 125 are located at intersections of the word lines 112 and the bit lines 114 (e.g., at each bit line/word line crossing). Although in Figure 1B, the access lines 112 are word lines and the access lines 114 are bit lines, in a number of embodiments, the access lines 112 may be bit lines and the access lines 114 may be word lines.

The memory cells 125 may be resistance variable memory cells, for example. The memory cells 125 may include a material programmable to different data states (e.g. a first data state 0 or a second data state 1). For example a memory cell could be in a set state (SET) or in a reset state (RST). For example, a memory cell in a SET state may correspond with a data state of 0 while a memory cell in a RST state may correspond to a data state of 1. In some embodiments a RST state may correspond with a data state 0 and a SET state may correspond to a data state of 1.

In some examples, each of memory cells 125 may include a single material, between a top electrode (e.g., top plate) and a bottom electrode (e.g., bottom plate), that may serve as a select element (e.g., a switching material) and a storage element, so that each memory cell 125 may act as both a selector device and a memory element. Such a memory cell may be referred to herein as a self-selecting memory cell. For example, each memory cell may include a chalcogenide material that may be formed of various doped or undoped materials, that may or may not be a phase-change material, and/or that may or may not undergo a phase change during reading and/or writing the memory cell. Chalcogenide materials (e.g., chalcogenide storage materials) may be materials or alloys that include at least one of the elements S, Se, and Te. Chalcogenide materials may include alloys of S, Se, Te, Ge, As, Al, Sb, Au, indium (In), gallium (Ga), tin (Sn), bismuth (Bi), palladium (Pd), cobalt (Co), oxygen (O), silver (Ag), nickel (Ni), platinum (Pt). Example chalcogenide materials and alloys may include, but are not limited to, Ge-Te, In-Se, Sb-Te, Ga-Sb, In-Sb, As-Te, Al-Te, Ge-Sb-Te, Te-Ge-As, In-Sb-Te, Te-Sn-Se, Ge-Se-Ga, Bi-Se-Sb, Ga-Se-Te, Sn-Sb-Te, In-Sb-Ge, Te-Ge-Sb-S, Te-Ge-Sn-O, Te-Ge-Sn-Au, Pd-Te-Ge-Sn, In-Se-Ti-Co, Ge-Sb-Te-Pd, Ge-Sb-Te-Co, Sb-Te-Bi-Se, Ag-In-Sb-Te, Ge-Sb-Se-Te, Ge-Sn-Sb-Te, Ge-Te-Sn-Ni, Ge-Te-Sn-Pd, or Ge- Te-Sn-Pt. Example chalcogenide materials can also include SAG-based glasses NON phase change materials such as SeAsGe. The hyphenated chemical composition notation, as used herein, indicates the elements included in a particular compound or alloy and is intended to represent all stoichiometries involving the indicated elements. For example, Ge-Te may include GexTey, where x and y may be any positive integer.

In various embodiments, memory cells 125 may have a threshold voltage. A threshold voltage may be a voltage magnitude specific to a memory cell or to a particular data state of a memory cell. Memory cells 125 may snap back in response to a magnitude of an applied voltage differential across them exceeding their threshold voltages. Such memory cells may be referred to as snapback memory cells. For example, a memory cell 125 may change (e.g., snap back) from a non-conductive (e.g., high impedance) state to a conductive (e.g., lower impedance) state in response to the applied voltage differential exceeding the threshold voltage. For example, a memory cell snapping back may refer to the memory cell transitioning from a high impedance state to a lower impedance state responsive to a voltage differential applied across the memory cell being greater than the threshold voltage of the memory cell. A threshold voltage of a memory cell snapping back may be referred to as a snapback event, for example. In contrast to a threshold voltage, a "sub-threshold voltage" is a voltage of a magnitude that would not cause a switching event to occur in the cell (e.g., a sub-threshold voltage that is less than the threshold voltage).

In this application, "applying a voltage differential" may also be referred to as "creating a bias". For example, creating a bias across a memory cell 125 may be the same applying a voltage differential across a memory cell 125. A bias can be created across a memory cell 125, across a pair of memory cells, across an access line 112, across an access line 114, or across a combination of access lines 112, 114 and memory cells 125.

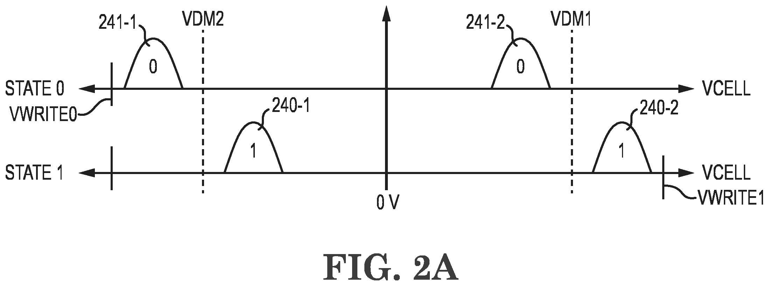

Figure 2A illustrates threshold distributions associated with various states of memory cells, such as memory cells 125 illustrated in Figure 1B, in accordance with an embodiment of the present disclosure. For instance, as shown in Figure 2A, the memory cells can be programmed to one of two possible data states (e.g., a first data state 0 or a second state 1). That is, Figure 2A illustrates threshold voltage distributions associated with two possible data states to which the memory cells can be programmed. A data state of a memory cell may correspond to a logical state of the memory cell.

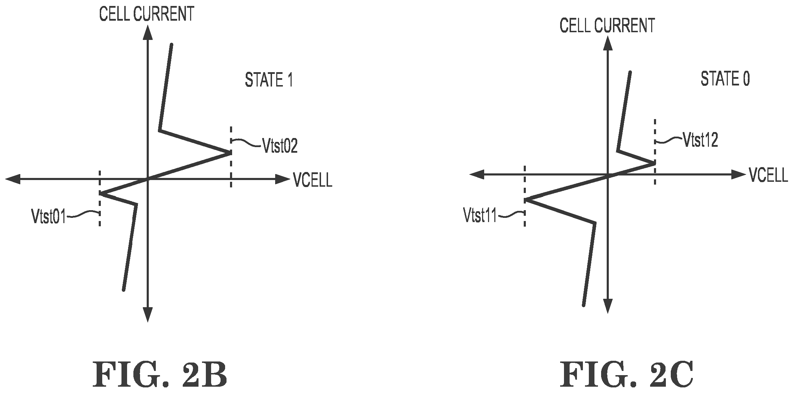

In Figure 2A, the voltage VCELL may correspond to a voltage differential applied to (e.g., across) the memory cell, such as the difference between a bit line voltage (VBL) and a word line voltage (VWL) (e.g., VCELL = VBL - VWL). The threshold voltage distributions (e.g., ranges) 240-1, 240-2, 241-1, and 241-2 may represent a statistical variation in the threshold voltages of memory cells programmed to a particular state. The distributions illustrated in Figure 2A correspond to the current versus voltage curves described further in conjunction with Figures 2B and 2C, which illustrate snapback asymmetry associated with assigned data states.

In some examples, the magnitudes of the threshold voltages of a memory cell 125 in a particular state may be asymmetric for different polarities, as shown in Figures 2A, 2B and 2C. For example, the threshold voltage of a memory cell 125 programmed to state 0 or state 1 may have a different magnitude in one polarity than in an opposite polarity. For instance, in the example illustrated in Figure 2A, a first data state (e.g., state 0) is associated with a first asymmetric threshold voltage distribution (e.g., threshold voltage distributions 241-1 and 241-2) whose magnitude is greater for a negative polarity than a positive polarity, and a second data state (e.g., state 1) is associated with a second asymmetric threshold voltage distribution (e.g., threshold voltage distributions 240-1 and 240-2) whose magnitude is greater for a positive polarity than a negative polarity. In such an example, an applied voltage magnitude (e.g., bias) sufficient to cause a memory cell 125 to snap back can be different (e.g., higher or lower) for one applied voltage polarity than the other.

Figure 2A illustrates demarcation voltages VDM1 and VDM2, which can be used to determine the state of a memory cell (e.g., to distinguish between states as part of a read operation). In this example, VDM1 is a positive voltage used to distinguish cells in state 0 (e.g., in threshold voltage distribution 241-2) from cells in state 1 (e.g., threshold voltage distribution 240-2). Similarly, VDM2 is a negative voltage used to distinguish cells in state 1 (e.g., threshold voltage distribution 240-1) from cells in state 0 (e.g., threshold voltage distribution 241-1). In the examples of Figures 2A-2C, a memory cell 125 in a positive state 1 does not snap back in response to applying VDM1; a memory cell 125 in a positive state 0 snaps back in response to applying VDM1; a memory cell 125 in a negative state 1 snaps back in response to applying VDM2; and a memory cell 125 in a negative state 0 does not snap back in response to applying VDM2. One or more embodiments provide that a demarcation voltage may be utilized as a sub-threshold voltage, as discussed herein.

Embodiments are not limited to the example shown in Figure 2A. For example, the designations of state 0 and state 1 can be interchanged (e.g., distributions 241-1 and 241-2 can be designated as state 1 and distributions 240-1 and 240-2 can be designated as state 0).

Figures 2B and 2C are examples of current-versus-voltage curves corresponding to the memory states of Figure 2A, in accordance with an embodiment of the present disclosure. As such, in this example, the curves in Figures 2B and 2C correspond to cells in which state 1 is designated as the higher threshold voltage state in a particular polarity (positive polarity direction in this example), and in which state 0 is designated as the higher threshold voltage state in the opposite polarity (negative polarity direction in this example). As noted above, the state designation can be interchanged such that state 0 could correspond to the higher threshold voltage state in the positive polarity direction with state 1 corresponding to the higher threshold voltage state in the negative direction.

Figures 2B and 2C illustrate memory cell snapback as described herein. VCELL can represent an applied voltage across the memory cell. For example, VCELL can be a voltage applied to a top electrode corresponding to the cell minus a voltage applied to a bottom electrode corresponding to the cell (e.g., via a respective word line and bit line). As shown in Figure 2B, responsive to an applied positive polarity voltage (VCELL), a memory cell programmed to state 1 (e.g., threshold voltage distribution 240-2) is in a non-conductive state until VCELL reaches voltage Vtst02, at which point the cell transitions to a conductive (e.g., lower resistance) state. This transition can be referred to as a snapback event, which occurs when the voltage applied across the cell (in a particular polarity) exceeds the cell's threshold voltage. Accordingly, voltage Vtst02 can be referred to as a snapback voltage. In Figure 2B, voltage Vtst01 corresponds to a snapback voltage for a cell programmed to state 1 (e.g., threshold voltage distribution 240-1). That is, as shown in Figure 2B, the memory cell transitions (e.g., switches) to a conductive state when VCELL exceeds Vtst01 in the negative polarity direction.

Similarly, as shown in Figure 2C, responsive to an applied negative polarity voltage (VCELL), a memory cell programmed to state 0 (e.g., threshold voltage distribution 241-1) is in a non-conductive state until VCELL reaches voltage Vtst11, at which point the cell snaps back to a conductive (e.g., lower resistance) state. In Figure 2C, voltage Vtst12 corresponds to the snapback voltage for a cell programmed to state 0 (e.g., threshold voltage distribution 241-2). That is, as shown in Figure 2C, the memory cell snaps back from a high impedance non-conductive state to a lower impedance conductive state when VCELL exceeds Vtst12 in the positive polarity direction.

In various instances, a snapback event can result in a memory cell switching states. For instance, if a VCELL exceeding Vtst02 is applied to a state 1 cell, the resulting snapback event may reduce the threshold voltage of the cell to a level below VDM1, which would result in the cell being read as state 0 (e.g., threshold voltage distribution 241-2). As such, in a number of embodiments, a snapback event can be used to write a cell to the opposite state (e.g., from state 1 to state 0 and vice versa).

Figures 3A-3B are diagrams illustrating memory cells capable of storing values associated with COPY and NOT operations in accordance with a number of embodiments of the present disclosure. As illustrated in Figure 3A, memory cells 325A-1 and 325A-2 may be connected in series along top line 330A which may be an access line (e.g. access line 112 or 114 shown in Figure 1B) connected to the top electrode 331A-1 of the memory cell 125A-1 and to the top electrode 331A-2 of the memory cell 325A-2. The top line 330A may be an access structure that may be activated by a voltage or bias being applied to it. The access structure may become conductive when it is activated. A bias created across the top line may be a voltage applied separately from a voltage used to read or program a memory cell or from a voltage applied to perform a logical operation. A bias created to activate the top line may be applied substantially simultaneously with a voltage applied to perform a logical operation. The bias created to activate the top line may electrically couple memory cells for use in logical operations. Creating a bias across the top line 330A may be a means of selecting memory cells for read or write operations and for logical operations, such as a COPY or NOT operation.

As used herein, the term "substantially" means that the characteristic need not be absolute, but is close enough so as to achieve the advantages of the characteristic. For example, "substantially simultaneously" is not limited to operations that are performed absolutely simultaneously and can include timings that are intended to be contemporaneous but due to manufacturing limitations may not be precisely simultaneously.

The memory cells 325A-1 and 325A-2 may be read and programmed using voltages such as those described in connection with Figures 2A-2C. The memory cells 325A-1 and 325A-2 may also have a voltage applied to both of them while connected in series along top line 330A. The memory cells 325A-1 and 325A-2 have a matching state (e.g. state 0), which indicates that each memory cell 325A-1 and 325A-2 may have a low (e.g., relatively lower) threshold (e.g., "Vtst12" shown in Figure 2C) at its bottom electrode 332A-1 and 332A-2 and a high (e.g., relatively higher) threshold (e.g., "Vtst11" shown in Figure 2C) at its top electrode 331A-1 and 331A-2. Due to the polarity of the voltage (e.g., positive at the bottom electrode 332A-1 of the memory cell 325A-1 and negative at the bottom electrode 332A-2 of the memory cell 325A-2) applied across the memory cells 325A-1 and 325A-2 in series (e.g., a voltage signal applied in the direction of the bottom electrode of the memory cell 325A-1 to the top or bottom electrode of the memory cell 325A-2), the memory cells 325A-1 and 325A-1 can be described as having a "LOW AND HIGH" threshold voltage because the bottom electrode 332A-1 of the memory cell 325A-1 has a "low" threshold, while the top electrode 331A-2 of the memory cell 325A-2 has a "high" threshold.

As illustrated in Figure 3B, memory cells 325B-1 and 325B-2, also connected by a top line 330B, have opposite states (e.g. memory cell 325B-1 in state 1, corresponding to a RST state in this case, and memory cell 325B-2 in state 0), which indicates that the memory cell 325B-1 has a high (e.g., relatively high) threshold (e.g., "Vtst02" shown in Figure 2B) at its bottom electrode 332B-1 and a low (e.g., relatively low) threshold at its top electrode 331B-2 (e.g., "Vtst01" shown in Figure 2B). In contrast to Figure 3A, the memory cells 325B-1 and 325B-2 can be described as having a "HIGH AND HIGH" threshold voltage This is because the bottom electrode 332B-1 of the memory cell 325B-1 has a "high" threshold in response to the voltage, while the top electrode 331B-2 of the memory cell 325B-2 (e.g., coupled to the access line 330B) also has a "high" threshold in response to the voltage.

Figure 3C illustrates threshold voltage distributions associated with states of memory cells connected in series in accordance with a number of embodiments of the present disclosure. The threshold voltages of the memory cells 325A-1, 325A-2 shown in Figure 3A are labeled "LOW AND HIGH" while the memory cells 325A-1, 325A-2 shown in Figure 3B are labeled "HIGH AND HIGH". VDM-write is marked with a dashed line denoting a voltage that is between the two threshold voltages.

Applying a voltage ("VDM-write") causes the memory cells 325A-1 and 325A-2 shown in Figure 3A to experience the voltage unevenly due to their different resistive states. The voltage ("VDM-write") applied across the memory cells 325A-1, 325A-2 can be distributed across the memory cells, for example, proportional to the "LOW AND HIGH" thresholds of the memory cells 325A-1, 325A-2. For example, the memory cell 325A-1, to which the voltage "VDM-write" is applied from the bottom electrode of the memory cell 325A-1 having a low threshold, switches its resistance state from a non-conductive state to a conductive state. Due to the memory cell 325A-1 may require a small voltage drop to conduct (because of the relatively small voltage conducting on its positive side shown in Figure 2C), the memory cell 325A-1 may "use" only a small fraction of the voltage "VDM-write" applied across the memory cells 325A-1, 325A-2. As such, a relatively larger fraction of the voltage "VDM-write" can be applied across the memory cells 325A-2 (or is required for the memory cell 325A-2 to conduct), which can cause a snapback event that reduces the threshold voltage of memory cell 325A-2 below "VDM2", shown in Figure 2A, changing the state of memory cell 325A-2 (e.g., the state of memory cell 325A-2 changes from state 0 to state 1).

Applying a voltage as depicted in Figure 3B, the memory cells 325B-1 and 325B-2 experience the same voltage due to them having the same threshold/resistance (e.g., "Vtst02" shown in Figure 2B or "Vtst11" shown in Figure 2C). Because the voltage that is split evenly is designed to not exceed the high threshold (of the memory cells 325B-1 and 325B-2) the memory cells 325B-1 and 325B-2 do not experience a snapback event and remain in the same state (e.g., "0" or "1").

A voltage between the "LOW AND HIGH" threshold voltage and the "HIGH AND HIGH" threshold voltage, such as the voltage noted as "VDM-write" in Figure 3C, could be applied as in Figures 3A and 3B and alter the value stored only in memory cell 325A-2. That property allows a NOT operation to be conducted provided the memory cells are in the configurations depicted in Figures 3A and 3B. Memory cells 325A-2 and 325B-2 may be buffer cells storing the result of the NOT operation. The buffer cells can be preset (e.g., programmed) to a desired state (e.g. state 0) prior to applying a voltage across a pair of cells in series (e.g., as part of a first NOT operation of a COPY operation). The polarity of the voltage applied to memory cells 325 can determine the threshold voltage across the cell. Applying a voltage that will give a buffer cell (e.g. memory cells 325A-2 and 325B-2) a high threshold voltage for that state (e.g. negative polarity in state 0 and positive polarity in state 1) the memory cells 325 can be either in the "HIGH AND HIGH" arrangement (e.g. Figure 3B) or the "LOW AND HIGH" arrangement (e.g. Figure 3A).

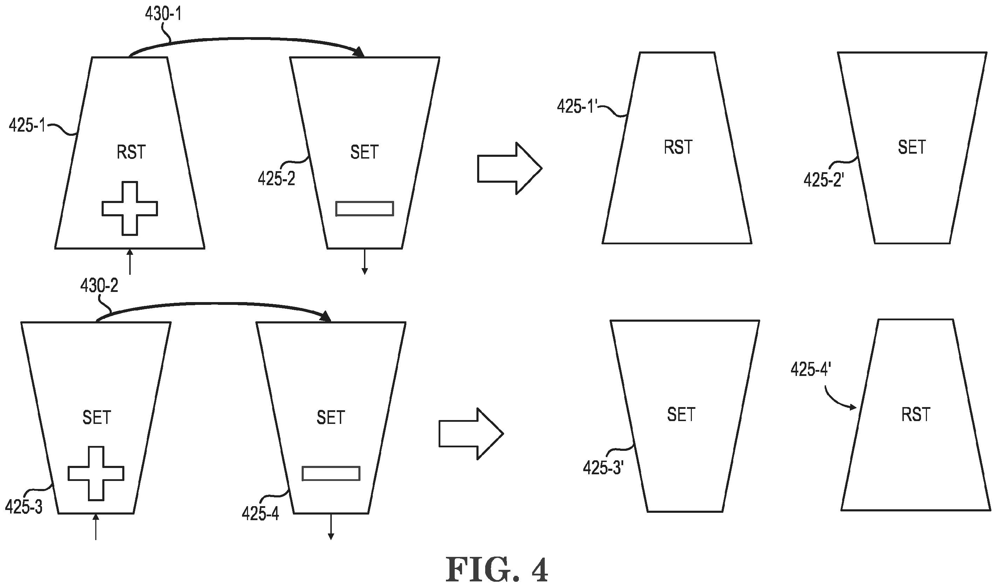

Figure 4 illustrates a number of memory cells in association with performing COPY and NOT operations in accordance with a number of embodiments of the present disclosure. For example, Figure 4 illustrates various states (e.g., "1" or "0") of memory cells (e.g., memory cells 425-1, 425-2, 425-3, and 425-4, collectively referred to as "memory cells 425") in association with performing a first NOT operation that is part of two NOT operations performed to eventually result in a COPY operation, as described herein. For example, Figure 4 illustrates a first NOT operation performed using values stored in memory cells 425-1 and 425-3, respectively, such that results of the first NOT operation are respectively stored in memory cells 425-2 and 425-4. As used herein, memory cells on which first NOT operations (part of a COPY operation) are performed can be referred to as "source cells", while memory cells on which results of first NOT operations are stored can be referred to as "buffer cells". Memory cells 425-1', 425-2', 425-3', and 425-4' can be analogous to memory cells with respective resulting states (as a result of performance of the first NOT operation using memory cells 425-1, 425-2, 425-3, and 425-4).

As shown in Figure 4, top lines 430-1 and 430-2 connect memory cells 425. For example, memory cells 425-1, 425-2 are coupled to one another via an access line 430-1, while memory cells 425-3, 425-4 are coupled to one another via an access line 430-2.

A NOT operation can be performed by applying a voltage ("VDM-write" shown in Figure 3C) across a source cell 425-1 or 425-3 and a buffer cell 425-2 or 425-4 connected in series. The buffer cell in a NOT operation may be preset to a desired state prior to the NOT operation being performed. Presetting the buffer cell may be accomplished by applying a voltage across the buffer cell greater than Vwrite0 depicted in Figure 2A. The source cells 425-1 and 425-3 may store data that will be the input (alternatively referred to as "subject") of the NOT operation. During a NOT operation, the inverted value of the data may be stored on the buffer cells 425-2 and 425-4.

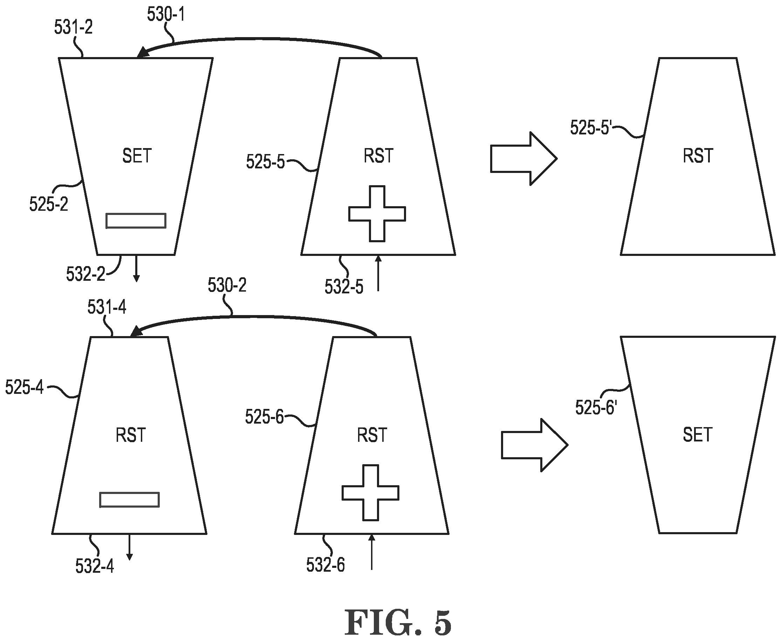

Once a NOT operation has been completed, the state (e.g. state 1, state 0) of the source cell (e.g. memory cells 425-1 and 425-3) remains the same, and the state (e.g. state 1, state 0) of the buffer cell (e.g. memory cells 425-2 and 425-4) is the inverse of the state of the source cell. As further described in association with Figure 5, a second NOT operation can then be performed on the buffer cell to complete a COPY operation of the source cell. The result of the second NOT operation may be stored on a destination cell.

In some embodiments an error detection and correction operation can be performed on the buffer cell once a first NOT operation (as described in association with Figure 4) has been completed. The error detection and correction operation may ensure data reliability of the buffer cell. Although embodiments are not so limited, an error detection and/or correction operation that can be performed on the buffer cell can include parity check, data scrub, etc., among others. As used herein, the term "parity check operation" refers to an operation performed to detect errors within data values by evaluating the parity of a defined set of bits (e.g., even or odd parity) and comparing it to an expected parity value, thereby enabling identification of single-bit or certain multi-bit errors in the data. As used herein, the term "data scrub operation" refers to an operation performed to correct, if any, an error within data values stored in a group of memory cells and rewrite the error-corrected data pattern to the group of memory cells.

Figure 5 illustrates a number of memory cells in association with performing COPY and NOT operations in accordance with a number of embodiments of the present disclosure. Memory cells 525-2 and 525-4 (e.g., buffer cells) may be analogous to memory cells 425-2' and 425-4' for the purposes of completing a COPY operation after a previous NOT operation ("first NOT operation") by performing a second NOT operation as described in association with Figure 5. More particularly, Figure 5 describes performing a second NOT operation using an input (stored in the memory cell 525-2 or memory cell 525-4) with a result of the second NOT operation to be stored on the memory cell 525-5 or memory cell 525-6.

As shown in Figure 5, memory cells 525-2 and 525-5 are connected by top line 530-1 and memory cells 525-4 and 525-6 are connected by top line 530-2. Top lines 530-1 and 530-2 may be access lines Memory cells 525-2, 525-5, 525-4, and 525-6 each have a bottom electrode 532-2, 532-5, 532-4, and 532-6. The bottom electrodes 532-2 and 5323-5 of memory cells 525-2 and 525-5 are opposite the connection to the top line 530-1. The bottom electrodes 532-4 and 532-6 of memory cells 525-4 and 525-6 are opposite the connection to the top line 530-2. The bottom electrodes 532-2, 532-5, 532-4, and 532-6 may connect the memory cells 525-2, 525-5, 525-4 and 525-6 to access lines other than the top lines 530-1 and 530-2.

As used herein, memory cells 525-5 and 525-6 to which results of COPY operations are respectively to be stored can be referred to as "destination cells". Memory cells 525-5' and 525-6' are analogous to memory cells with respective states (e.g., "1" or "0") subsequent to performing the second NOT operation.

In some embodiments an error detection and correction operation may be performed on the buffer cell after a first NOT operation (as described in association with Figure 4) of a COPY operation but before the second NOT operation of a COPY operation. An error detection and correction operation may ensure data reliability of the buffer cell which can further strengthen the data reliability of the destination cell once a second NOT operation (as described in association with Figure 5) is performed. If an error is detected in the buffered data (e.g., data stored in a buffer cell subsequent to the first NOT operation, but before performing the second NOT operation), a correction operation may be performed directly within the buffer cell. This may involve selectively overwriting bits of the buffered data to reflect corrected values. Once the data in the buffer cell is verified as correct, the second NOT operation can be allowed to be performed.

As illustrated in Figure 5, destination cells 525-5 and 525-6 can be preliminarily (e.g., prior to the second NOT operation) preset to a desired state (e.g., "RST" or state 1). The destination cells 525-5 and 525-6 are in the desired state when they have a high threshold voltage (e.g., "Vtst02" shown in Figure 2B) at its bottom electrode such that the voltage "VDM-write" is applied against the high threshold voltage. For example, a voltage with a positive polarity applied to the bottom electrode of a memory cell in a "RST" state would need to exceed the high threshold voltage to trigger a snapback event. If the buffer cell (e.g., the buffer cell 525-2) is in a "SET" state such that the buffer cell has a high threshold voltage (e.g., "Vtst11" shown in Figure 2C) at its top electrode (e.g., top electrode 531-2 coupled to the access line 530-1), the voltage "VDM-write" is applied against the high threshold voltage of the buffer cell, resulting in the application of "VDM-write" across memory cells (e.g., memory cells 524-2, 525-5) in a "HIGH AND HIGH" arrangement shown in Figure 3B.

Applying the same voltage across memory cells 525-2 and 525-5, memory cells 525-2 and 525-5 experience the same voltage due to having the same resistance. For example, the voltage may be distributed between the memory cells 525-2 and 525-5 proportional to their resistance. In this case, because the resistance of the memory cells 525-2 and 525-5 is the same substantially (due to "HIGH AND HIGH" arrangement), the voltage is split evenly between the two memory cells 525-2 and 525-5, and as a result the voltage applied does not exceed the threshold voltage for either, and they maintain their state (e.g. state 0 for memory cell 525-2 and state 1 for memory cell 525-5).

If the buffer cell (e.g., the buffer cell 525-4) is in a "RST" state such that the buffer cell has a low threshold voltage (e.g., "Vtst01" shown in Figure 2B) at its top electrode (e,g,, 531-4 coupled to the access line 530-1), the voltage "VDM-write" is applied against the low threshold voltage of the buffer cell, resulting in the application of "VDM-write" across memory cells (e.g., memory cells 525-4, 525-6) in a "LOW AND HIGH" arrangement similarly shown in Figure 3A.

Applying a voltage that is above the "LOW AND HIGH" threshold voltage causes the memory cells 525-4 and 525-6 to experience the voltage unevenly due to their different resistive states. For example, the voltage may be distributed across the memory cells 525-4 and 525-6 proportionally to the resistance of each memory cell. More particularly, memory cell 525-6 may experience a larger voltage due to having a higher resistance (which is due to a higher threshold voltage, such as "Vtst02" shown in Figure 2B). In the case where the applied voltage "VDM-write" exceeds the "LOW AND HIGH" threshold voltage, memory cell 525-6 may experience a voltage larger than Vtst02, depicted in Figure 2B, causing change of the state of memory cell 525-6 (e.g., the state of memory cell 525-6 changes from state 1 to state 0). The result of the NOT operation on memory cell 525-6 is depicted by memory cell 525-6'.

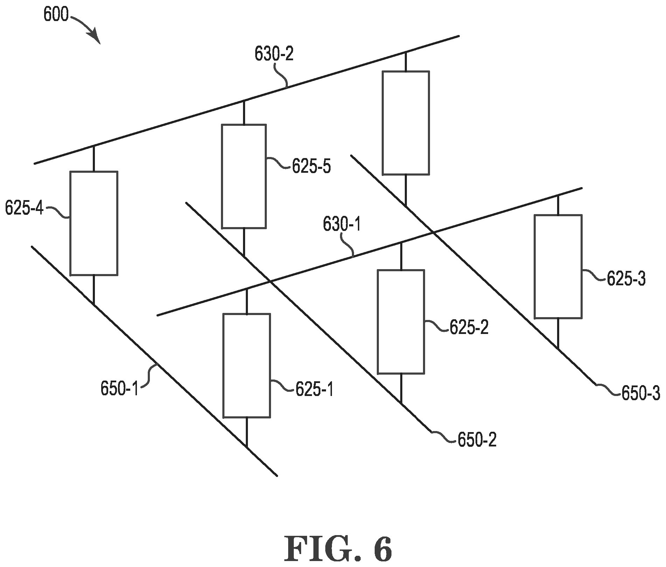

Figure 6 illustrates a portion of a memory array 600 including memory cells 625-1, 625-2, and 625-3 (collectively memory cells 625) that can be operated to perform a COPY or NOT operation in accordance with a number of embodiments of the present disclosure. Memory cells 625 are coupled (e.g., connected) between two access lines, such as first access lines 630-1, 630-2 (alternatively referred to as "top access lines") and second access lines 650-1, 650-2, 650-3 (alternatively referred to as "bottom access lines"). For example, memory cells 625-1, 625-2, 625-3 are coupled between the top access line 630-1 and bottom access lines 650-1, 650-2, 650-3, respectively, while a memory cell 625-4 is coupled between the top access line 630-2 and the bottom access line 650-1. Top access lines 630-1, 630-2 can be a sense line and bottom access lines 650-1, 650-2, 650-3 can be a word line, or vice versa.

Although embodiments are not so limited, memory cell 625-1 may be a source cell on which a NOT operation may be performed. When connected to a buffer cell in series along top line 630-1, memory cell 625-3 may be the buffer cell, to which a result of the NOT operation can be stored. In some embodiments, 625-2 could also serve as a buffer cell. In some embodiments, memory cell 625-1 may be connected to a buffer cell in series along bottom line 650-1. In that case, memory cell 625-4 may be used as a buffer cell.

Top lines 630-1, 630-2 can function as a shared access line to connect two memory cells to perform a NOT operation using the two memory cells. In one example, memory cells (e.g., memory cells 625-1, 625-2) can be electrically connected to one another in series via the top access line 630-1 such that the memory cell 625-1 can function as a source cell, while the memory cell 625-2 can function as a buffer cell (such that a result of the NOT operation is stored on the memory cell 625-2), or vice versa, as described in connection with Figures 3A, 3B, 3C, 4, and 5. Subsequently, the buffer memory cell (e.g., memory cell 625-2) can be electrically connected to a destination cell (e.g., memory cell 625-3) via the top access line 630-1 to perform a subsequent NOT operation, which can result in a COPY operation with a result of the COPY operation stored in the destination cell 625-3. Alternatively, the buffer memory cell (e.g., memory cell 625-2) can be electrically connected to a destination cell (e.g., a memory cell 625-5 coupled between the access lines 630-2 and 650-2) via the bottom access line 650-2 to perform a subsequent NOT operation, which can result in a COPY operation with a result of the COPY operation stored in the destination cell.

In another example, memory cells (e.g., memory cells 625-1, 625-4) can be electrically connected to one another in series via the bottom access line 650-1 such that the memory cell 625-1 can function as a source cell, while the memory cell 625-4 can function as a buffer cell (such that a result of the NOT operation is stored on the memory cell 625-2), or vice versa, as described in connection with Figures 3A, 3B, 3C, 4, and 5. Similarly and as described herein, a subsequent NOT operation can be performed using the buffer cell and a destination memory cell coupled to the buffer cell via either top access line (e.g., 630-2) or bottom access line (e.g., 650-1).

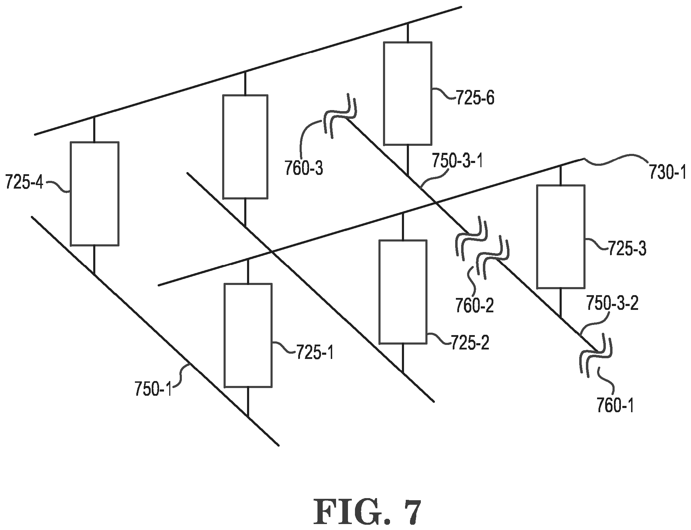

Figure 7 illustrates a portion of a memory array 700 including memory cells 725-1, 725-2, 725-3 and 725-6 that can be operated to perform a COPY or NOT operation in accordance with a number of embodiments of the present disclosure. The memory array 700 can be analogous to the memory array 100 shown in Figure 1. For example, NOT and/or COPY operations that can be performed on those memory cells of the memory array 700 can be analogous to a COPY operation and/or any one of two NOT operations (e.g., first and second NOT operations respectively performed on source and buffer cells as described in connection with Figure 4 or buffer and destination cells as described in connection with Figure 5) to complete the COPY operation as described in connection with Figures 3, 4, and 5.

In some embodiments, it may be advantageous to designate buffer cells from a plurality of memory cells in an array (e.g., memory array 100) for performing NOT and COPY operations. In some embodiments, it may be advantageous to electrically isolate the memory cells designated buffer cells from each other to prevent the NOT operation from unintentionally altering the value of (e.g., neighbor) memory cells other than the buffer cell. In Figure 7, memory cell 725-3 is a designated buffer cell and is electrically isolated from the adjacent designated buffer cell 725-6. Electrically isolating buffer cells from one another may be accomplished during manufacture of a memory device (e.g., the memory array 100 shown in Figure 1A) and may be accomplished by creating isolation trenches, such as trenches 760-1, 760-2, 760-3 (e.g., collectively referred to as trenches 760) shown in Figure 7.

An isolation trench 760-2 may interrupt (e.g., electrically disconnect) a conductive path, in this example access line 750-3-1 and 750-3-2, connecting memory cells 725-3 and 725-6. For example, the trench 760-2 can be formed between access lines 750-3-1 and 750-3-2 to electrically isolate them from each other. This, in turn, can further electrically isolate memory cell 725-6 from memory cell 725-3, or vice versa. Although not shown in Figure 7, the trenches 760-1, 760-2, and 760-3 can further isolate memory cells 725-3 and 725-6 from adjacent memory cells.

A trench such as trenches 760-1, 760-2, and 760-3 may be formed by removing material from the memory device so that access lines 750-3-1 and 750-3-2 do not form a conductive path between memory cells 725-3 and 725-6. The space left by the removed material may be filled with dielectric materials, insulative materials, or a combination of the two. In some cases, a conductive material may be used to fill the trench 760-2 provided an insulative or dielectric layer is included to interrupt the conductive path.

A NOT operation or a COPY operation (performed on a memory array with isolated buffer cells such as memory cell 725-3) may be performed on memory cells sharing a top line 730 with the buffer cell. The isolated buffer cells 725-1 and 725-6 may be memory cells at the edge of a memory array allowing the buffer cells to be isolated without interfering with other memory cells in the memory array 700. As an example, a NOT operation may be performed on memory cell 725-1 and buffer cell 725-3 with the result being stored on buffer cell 725-3. Another NOT operation can then be performed on buffer cell 725-3 and memory cell 725-2 with the result being stored on memory cell 725-2. After both NOT operations are performed the value on memory cell 725-1 will have been copied to memory cell 725-2. The source cell (e.g., the source cell 425-1, 425-3) and the destination cell (e.g., the destination cell 525-5, 525-6) may both need to share a top line with the buffer cell used in the COPY or NOT operation in this case.

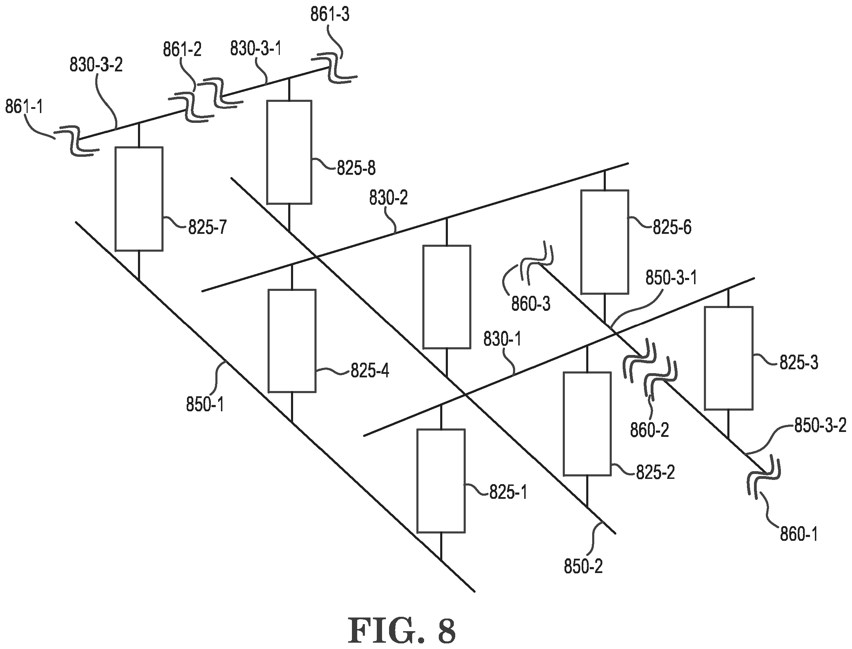

Figure 8 illustrates a portion of a memory array 800 including memory cells 825-1 825-2, 825-3, 825-4, 825-6, 825-7, and 825-8 that can be operated to perform COPY and NOT operations in accordance with a number of embodiments of the present disclosure. The memory array 800 can be analogous to the memory array 100 shown in Figure 1. For example, NOT and/or COPY operations that can be performed on those memory cells of the memory array 800 can be analogous to a COPY operation and/or any one of two NOT operations (e.g., first and second NOT operations respectively performed on source and buffer cells as described in connection with Figure 4 or buffer and destination cells as described in connection with Figure 5) to complete the COPY operation as described in connection with Figures 3, 4, and 5.

In this embodiment memory cells 825-3, 825-6, 825-7, and 825-8 may be designated buffer cells (analogous to designated buffer cells 725-3 and 725-6 of Figure 7). Memory cells 825-3 and 825-6 may be used to perform COPY operations along a single top line 830-1 or 830-2. Memory cells 825-7 and 825-8 may be used to perform COPY operations along a single bottom line 850-1 or 850-2. A COPY operation performed on memory cell 825-1 with the result stored on memory cell 825-2 may use memory cell 825-3, a designated buffer cell, as the buffer cell. A COPY operation performed on memory cell 825-1 with the result stored on memory cell 825-4 may use memory cell 825-7, a designated buffer cell, as the buffer cell.

Memory cells 825-3, 825-6, 825-7, and 825-8 may be designated buffer cells because they are electrically isolated from adjacent buffer cells. Isolation trenches 860-1, 860-2, and 860-3 can interrupt the path of conduction along bottom lines 850-3-1 and 850-3-2, electrically isolating designated buffer cells 825-6 and 825-3 from each other and adjacent memory cells (not pictured). Isolation trenches 861-1, 861-2, and 861-3 interrupt the path of conduction along top lines 830-3-1 and 830-3-2, electrically isolating designated buffer cells 825-7 and 825-8 from each other and adjacent memory cells (not pictured). Electrically isolated buffer cells may perform COPY operations with fewer errors than if they were not electrically isolated.

A memory array 800 including memory cells 825-7 and 825-8 (isolated along the top lines 830-3-1 and 830-3-2) in addition to memory cells 825-3 and 825-6 (isolated along the bottom lines 850-3-1 and 850-3-2) may allow for more memory cells to be available for use as a destination cell as discussed in reference to Figure 5. For example, if the memory cell 825-1 is the source cell such as memory cells 425-1 and 425-3 of Figure 4, for a COPY operation, the memory cell 825-3 or the memory cell 825-7 could be used as a buffer cell. Therefore, either memory cell 825-4 or memory cell 825-2 may be used as a destination cell. While not pictured in the portion of the memory array 800 in Figure 8, memory cell 825-1 may share a top line with a plurality of memory cells in addition to the memory cell 825-2 and the memory cell 825-3, which may be a designated buffer cell. Performing a COPY operation designating the memory cell 825-1 as the source cell may allow for any of a plurality of memory cells sharing a top line 830-1 with the memory cell 825-1, provided memory cell 825-3 is selected as the buffer cell for the COPY operation.

Similarly, a plurality of memory cells may share the same bottom line 850-1 and not the same top line 830-1 as the memory cell 825-1. Selecting the memory cell 825-7, which may be a designated buffer cell, as the buffer cell for a COPY operation designating the memory cell 825-1 as the source cell may allow a destination cell to be selected from a plurality of memory cells (not pictured) sharing a bottom line 850-1 with the memory cell 825-1. The number of memory cells available to be selected as destination cells may be increased if the memory array contains designated buffer cells isolated along the top lines 830-3-1 and 830-3-2 (e.g., memory cells 825-7 and 825-8) as well as designated buffer cells isolated along the bottom lines 850-3-1 and 850-3-2 (e.g., memory cells 825-3 and 825-6).

In some embodiments, copy operations performed using data stored in memory cells (e.g., memory cells 625, 725, 825 illustrated in Figures 6-8, respectively) can also result in associating (re-associating) inversion bits associated with the data. As used herein, the term "inversion bits" refer to bits indicative of a polarity of the data (e.g., whether bits of the data are flipped or not for the purpose of consuming less power in transferring the data between, for example, the controller 104 and the memory array 110). When the data are copied to different locations (e.g., memory cells) as described in connection with Figures 7A and 7B, these new locations can be associated to those locations where the corresponding inversion bits are stored. For example, the controller 104 may "remap" mapping information to associate addresses where the inversion bits are stored to those address to which corresponding data are copied. Alternatively, the inversion bits associated with the copied data may also be copied to those locations associated with locations where the data are copied to.

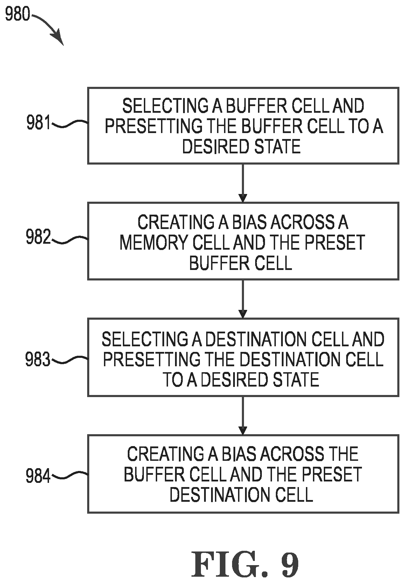

Figure 9 is a flow diagram corresponding to a method 980 for performing one or more logical operations in accordance with some embodiments of the present disclosure. The method 980 can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. In some embodiments, the method 980 is performed by the controller 104 and/or control circuitry 106 of Figure 1. Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

At 981, a memory cell, such as memory cells 425-2 and 425-4 of Figure 4, is selected to be a buffer cell. The selected buffer cell may be one of a plurality of designated buffer cells. The selected buffer cell is preset to a desired state. The desired state may correspond with a "SET" state (i.e., state 1) such that the selected buffer cell has a high threshold voltage when a voltage is applied at its top electrode.

At 982, a memory cell is selected as a source cell, for example, a memory cell to which a COPY operation is to be applied. The source cell and the selected buffer cell are connected in series along a top line such that the top electrode of the source cell is electrically coupled to the top electrode of the selected buffer cell. A voltage is then applied at the bottom electrode of the source cell such that it is applied across the source cell and the selected buffer cell along the top line. The applied voltage may interact with the buffer cell at its top electrode due to the electrical coupling of the source cell and the selected destination cell.

The threshold voltage, such as the threshold voltages discussed in connection with Figure 3, of the selected buffer cell may be a high threshold voltage at the top electrode. The threshold voltage of the selected buffer cell may be influenced by the preset state of the selected buffer cell. The source cell may have a high threshold voltage (e.g., relatively higher) at its bottom electrode or a low threshold voltage (e.g., relatively lower) at its bottom electrode. The buffer cell and the source cell may have a "LOW AND HIGH" arrangement as discussed in connection with Figure 3A or a "HIGH AND HIGH" arrangement as discussed in connection with Figure 3B. A voltage such as VDM-write discussed in connection with Figure 3C may be applied across the source cell and the buffer cell in series to perform a first NOT operation. After the voltage (e.g., VDM-write) is applied, a state of the source cell may be unchanged and the state of the buffer cell may be the inverse of the state of the source cell.

At 983, a memory cell, such as memory cells 525-5 and 525-6 of Figure 5, is selected to be a destination cell. The selected destination cell may be one of a plurality of memory cells. The selected destination cell is preset to a desired state. The desired state may correspond with a "RST" state (i.e., state 0) such that the selected buffer cell has a high threshold voltage when a voltage is applied at its bottom electrode.

At 984, the buffer cell, having a state opposite the source cell as memory cells 425-2' and 425-4' of Figure 4, and the destination cell, set to a preset state as memory cells 525-5 and 525-6 of Figure 5, are electrically coupled in series. While coupled, a voltage, (e.g., VDM-write) applied at the bottom electrode of the destination cell, along a top line to the top electrode of the buffer cell may result in a "HIGH AND HIGH" threshold voltage arrangement or a "LOW AND HIGH" threshold voltage arrangement as. After the voltage is applied, the destination cell may have a state opposite the buffer cell, and therefore, a state matching the state of the source cell.

The method 980 may be triggered by a dedicated command. The dedicated command may identify the memory cell to which a COPY operation is to be applied. The dedicated command may also identify memory cells to be used as a buffer cell and a destination cell. In some embodiments, a dedicated command may provide multiple memory cells on which a COPY operation is to be performed. Multiple copy operations on the multiple memory cells may be performed substantially simultaneously. Multiple copy operations on the multiple memory cells may also occur in sequence. For example a first not operation is performed on a first source cell and a first buffer cell, a second not operation is performed on the first buffer cell and a first destination cell, then the process is repeated with a second source cell, a second buffer cell and a second destination cell. For some sequential COPY operations, the same buffer cell may be used in multiple operations. For multiple COPY operations occurring substantially simultaneously, separate buffer cells may be used for each COPY operation.

Although specific embodiments have been illustrated and described herein, those of ordinary skill in the art will appreciate that an arrangement calculated to achieve the same results can be substituted for the specific embodiments shown. This disclosure is intended to cover adaptations or variations of a number of embodiments of the present disclosure. It is to be understood that the above description has been made in an illustrative fashion, and not a restrictive one. Combination of the above embodiments and other embodiments not specifically described herein will be apparent to those of ordinary skill in the art upon reviewing the above description. The scope of a number of embodiments of the present disclosure includes other applications in which the above structures and methods are used. Therefore, the scope of a number of embodiments of the present disclosure should be determined with reference to the appended claims, along with the full range of equivalents to which such claims are entitled.

In the foregoing Detailed Description, some features are grouped together in a single embodiment for the purpose of streamlining the disclosure. This method of disclosure is not to be interpreted as reflecting an intention that the disclosed embodiments of the present disclosure have to use more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separate embodiment.

## Claims

1. An apparatus, comprising:
a plurality of memory cells (125; 325A-1, 325B-1; 425-1, 425-3; 525-5, 525-6; 625-1, ..., 625-5; 725-1, ..., 725-6; 825-1, ..., 825-8), each memory cell of the plurality having a respective first end (331A-1, 331A-2, 331B-1, 331B-2) and a respective second end (332A-1, 332A-2, 332B-1, 332B-2, 532-5, 532-6);
a plurality of buffer cells (325A-2, 325B-2; 425-2, 425-4; 525-2, 525-4; 725-3, 725-6; 825-3, 825-6, 825-7, 825-8), each buffer cell of the plurality having a respective first end (331A-2, 331B-2; 531-2, 531-4) and a respective second end (332A-2, 332B-2; 532-2, 532-4); and
control circuitry (106) configured to, in response to receipt of a dedicated command, perform a logical operation:
apply a first voltage having a first polarity across a first memory cell (425-1, 425-3) of the plurality of memory cells and a first buffer cell (425-2, 425-4) of the plurality of buffer cells such that a first portion of the first voltage is applied to the respective second end of the first memory cell and the respective first end of the first buffer cell, wherein, as a result of the voltage being applied, a logical state of the first memory cell is unchanged and a logical state of the first buffer cell is the opposite of the state of the first memory cell; and
apply a second voltage having a second polarity across a second memory cell (525-5, 525-6) of the plurality of memory cells and the first buffer cell (525-2, 525-4) such that a first portion of the second voltage is applied to the respective second end (532-5, 532-6) of the second memory cell and the respective first end (531-2, 531-4) of the first buffer cell, wherein, as a result of the second voltage being applied, a result of the logical operation is stored on the second memory cell.

2. The apparatus of claim 1, wherein the control circuitry is further configured to, in response to receipt of the dedicated command:
electrically couple, prior to applying the first voltage, the first memory cell and the first buffer cell via a first access line (112-0, ..., 112-N, 114-0, ..., 114-M; 330A, 330B; 430-1, 430-2), wherein the first memory cell and the first buffer cell are coupled to the first access line via the respective first end.

3. The apparatus of claim 1, wherein the control circuitry is further configured to, in response to receipt of the dedicated command:
electrically couple, prior to applying the second voltage, the second memory cell and the first buffer cell, wherein the second memory cell and the first buffer cell are coupled to the first access line or a second access line (530-1, 530-2) via the respective first end.

4. The apparatus of claim 1, wherein the control circuitry is further configured to, in response to receipt of the dedicated command:
program, prior to applying the first voltage, the buffer cell to a first logical state such that the respective first end of the buffer cell is associated with a relatively higher threshold than that associated with the respective second end of the buffer cell.

5. The apparatus of claim 1, wherein the control circuitry is further configured to, in response to receipt of the dedicated command:
program, prior to applying the second voltage, the second cell to a second logical state such that the respective second end of the second cell is associated with a relatively higher threshold than that associated with the respective first end of the buffer cell.

6. The apparatus of claim 1, wherein the plurality of buffer cells (725-3, 725-6; 825-3, 825-6) are coupled to a second access line (750-3; 850-3), which includes a number of trenches (760-1, 760-2, 760-3; 860-1, 860-2, 860-3) formed along the second access line to electrically isolate each buffer cell from the other buffer cells.

7. The apparatus of claim 2, wherein the first access line is one of a plurality of word lines.

8. The apparatus of claim 2, wherein the first access line is one of a plurality of sense lines.

9. The apparatus of claim 6, further comprising: a second plurality of buffer cells (825-7, 825-8) isolated from the plurality of buffer cells and coupled to a third access line (830-3), which includes a number of trenches (861-1, 861-2, 861-3) formed along the third access line to electrically isolate each buffer cell of the second plurality of buffer cells from the other buffer cells of the second plurality of buffer cells.

10. The apparatus of claim 1, wherein the control circuitry is to, in response to receiving a dedicated command perform a plurality of logical operations in parallel.

11. The apparatus of claim 1, wherein the logical state of the second memory cell, as a result of the second voltage being applied, is the same as a logical state of the first memory cell.

12. A method for copying a value stored in a memory cell, comprising:
presetting a value stored in a buffer cell (425-2, 425-4) to a desired state;
creating a first bias across the memory cell (425-1, 425-3) and the buffer cell in series, the first bias being sufficient to change the value of the buffer cell if the memory cell and the buffer cell are storing equivalent values;
presetting a value stored in a destination cell (525-5, 525-6) to a chosen value;
creating a second bias across the buffer cell and the destination cell in series, the second bias being sufficient to change the value of the destination cell if the destination cell and the buffer cell are storing equivalent values.

13. The method of claim 12, further comprising:
receiving a dedicated command before presetting the value stored in the buffer cell; wherein the dedicated command identifies the memory cell, the destination cell, and the buffer cell.

14. The method of claim 13, wherein the dedicated command identifies a plurality of memory cells (725-1, 725-4; 825-1, 825-2), a plurality of destination cells (725-2; 825-4), and a plurality of buffer cells (725-3, 725-6; 825-7, 825-8); and the method is applied to multiple memory cells of the plurality of memory cells substantially simultaneously.

15. The method of claim 12, further comprising:
electrically coupling the memory cell to the buffer cell prior to creating the first bias; and
coupling the buffer cell to the destination cell prior to creating the second bias.
